# EUROPEAN PATENT APPLICATION

(11) **EP 1 031 647 A2**
(43) Date of publication of application: **30.08.2000**
(21) Application number: 99303648.2
(22) Date of filing: 11.05.1999
(51) Int. Cl.: C25D 7/12, C25D 17/00, C25D 5/08, H01L 21/00

(54) **Apparatus and method for plating a wafer**

(30) Priority: 19.02.1999 US 253217
(71) Applicant: Solid State Equipment Corporation, Horsham, Pennsylvannia 19044 (US)
(72) Inventor: Itzkowitz, Herman, Bala Cynwyd, Pennsylvania 19004 (US)
(74) Representative: Perkins, Sarah

(57) **Abstract**

An apparatus for plating a wafer is provided having a support chamber and a plating tank. The support chamber has a circumferential wall provided with an open end, and a reduced diameter adjacent the open end for supporting the wafer to be plated above the plating tank. The support chamber has an interior volume for receiving a gas under pressure. The plating tank has a means for imparting a laminar flow to plating solution in the plating tank.

A method of plating a wafer is also disclosed, comprising transferring a wafer to a support chamber, supplying a gas under pressure in said support chamber, bringing the wafer to be plated into contact with plating solution in a plating tank, maintaining the wafer in contact with the plating solution for a preselected time, and separating the wafer from the plating solution.

## Description

The present invention relates to the field of manufacturing semiconductor wafers, in particular, the plating of a surface of a semiconductor wafer utilizing a support chamber and a plating tank.

In the field of manufacturing semiconductor wafers, it is necessary to deposit an electrically conductive layer on one surface of the wafer, to produce electrical interconnects between components found on the wafer. In order to accomplish this, the wafer must be uniformly coated on one side. The side of the wafer to be coated is referred to herein as the coated side. During the coating process, the edges of the wafer, as well as the side of the wafer which is to remain unplated, referred to herein as the opposite side of the water, must be masked or sealed off so that they do not come into contact with plating solution.

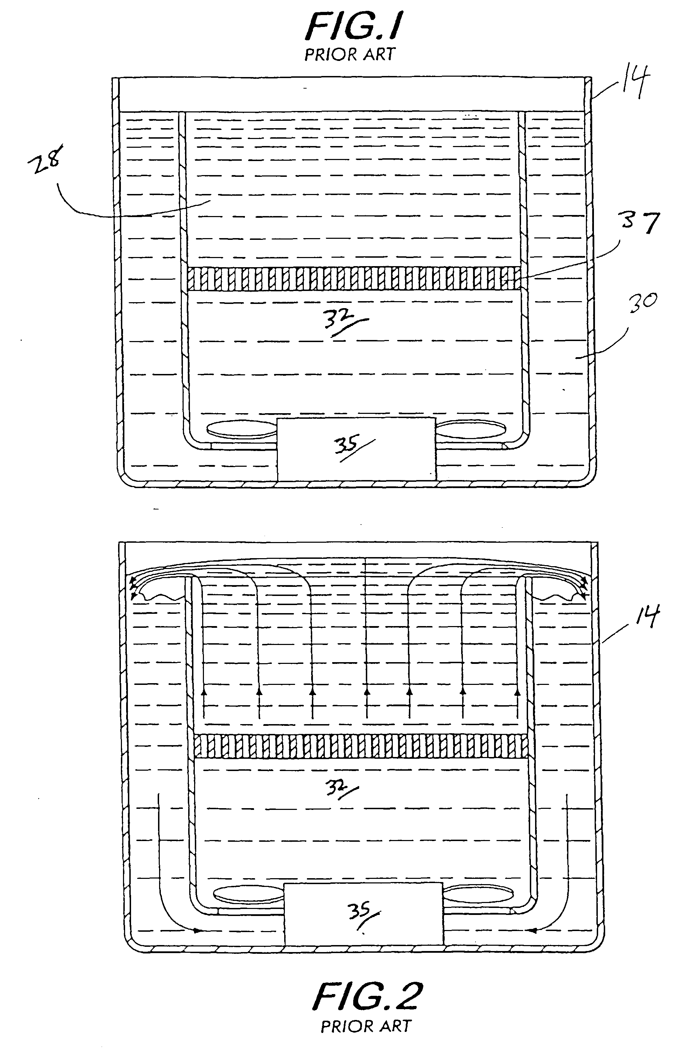

An effective method for depositing an electrically conductive layer on a wafer utilizes a chemical or electro-chemical plating tank. The most common of these plating tanks is known as a fountain plater, and is shown in Figures 1 and 2. As shown in Figure 1, fountain platers comprise a plating tank 14 filled with plating solution 32. An internal or external pump, shown in Figures 1 and 2 as an internal pump 35, is used to create a laminar flow of plating solution 32, represented by the arrows in Figures 1 and 2. As the rate of flow of plating solution 32 is increased, the surface of plating solution 32 will rise, as can be seen by comparing the static fluid level of Figure 1 with the circulating fluid level shown in Figure 2.

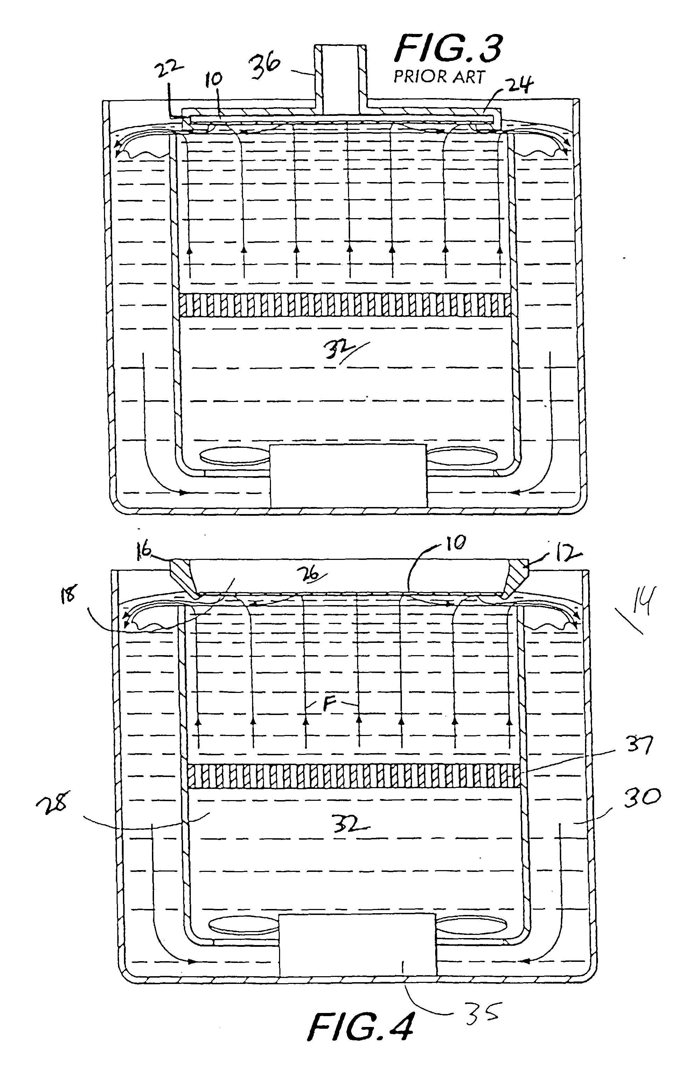

Figure 3 shows a silicon wafer 10 immersed in the plating tank 14 with plating solution 32 flowing across the surface 11 of the wafer 10. The wafer is usually held in a rigid mechanical manner by some form of chuck 36, as shown in Figure 3. The plating solution 32 must be applied only to one surface 11 of the wafer 10, the coated side, and must be kept some distance, typically 2-3 mm, away from the edge 22 of the wafer. If plating solution reaches the edge 22 or opposite side 24 of a wafer 10, the wafer is rendered unusable. Thus, in automated equipment, the apparatus and method for plating a wafer must be reliable and seals must be liquid tight, without causing damage to a fragile silicon wafer.

Methods currently used to seal or mask the areas of the wafer which are to remain unplated from contacting plating solution include the application of adhesive tape, the use of "O" ring seals, and various other mechanical seals.

Plating of semiconductor wafers using current methods and devices has a number of drawbacks. Applying too great a pressure to seal a wafer by clamping it in a rigid mechanical structure such as a chuck can damage the wafer during plating and cause cracking, rendering the wafer unusable. Morever, because the wafer has support at its edges, but no support at its center, the upward flow of the plating solution from the plating tank can flex the middle of the wafer, causing deformation or cracking.

In addition, current methods of mechanically sealing or masking wafers are not reliable, and plating solution may seep through and around the edges of the wafer, allowing plating solution to contact both the edges of the wafer as well as the opposite side of the wafer, which must remain unplated.

There is, accordingly, a need for an apparatus and method of plating a wafer wherein the edges and side of the wafer which are to remain unplated are protected from plating solution during the plating process.

There is also the need for an apparatus and method of plating a wafer wherein a minimal amount of stress is placed on the wafer during plating.

There is further the need for an apparatus and method of plating a wafer wherein a wafer is held in place during the plating process other than by rigid mechanical means.

The present invention is directed to an apparatus that satisfies the need for a support chamber and plating tank that is capable of plating a wafer while keeping plating solution from reaching the edges and opposite side of the wafer. The present invention is further directed to an apparatus that satisfies the need for a support chamber that does not apply unnecessary mechanical pressure to a wafer while supporting the wafer during the plating process. The present invention provides a truly innovative and effective solution to these needs.

An apparatus having features of the present invention comprises a support chamber for supporting a wafer above a plating tank. The support chamber has a circumferential wall with an open end. The circumferential wall has a reduced diameter adjacent the open end which defines a support for supporting a wafer above a plating tank. The support chamber has an interior volume for receiving a gas under pressure.

A plating tank is provided having an open end for receiving the support chamber therein. The plating tank has a means for imparting laminar flow to plating solution provided in the plating tank, causing the plating solution to rise to a preselected level.

A method for plating a wafer is also disclosed, comprising transferring a wafer to a support chamber, supplying a gas under pressure in said support chamber, bringing the wafer to be plated into contact with plating solution by increasing the flow of plating solution in the plating tank such that the level of plating solution rises to meet the surface of the wafer, maintaining the solution in contact with the surface of the wafer to be plated for a preselected time, and decreasing the flow of plating solution in the plating tank such that the level of plating solution falls below the surface of the wafer.

An embodiment of the present invention will now be described by way of example only, with reference to the accompanying drawings, in which:

**Figure 1** shows a cross sectional view of a prior art plating tank containing plating fluid, where the plating fluid is static.

**Figure 2** shows a cross sectional view of a prior art plating tank containing plating fluid, where the plating fluid has been caused to flow in a laminar fashion.

**Figure 3** shows a cross sectional view of a prior art plating tank, where a rigid mechanical member holds a wafer to be plated above the plating tank.

**Figure 4** shows a cross sectional view of a support chamber and plating tank in accordance with the present invention.

**Figure 5** shows an enlarged detailed cross sectional view of a portion of the support chamber and plating tank shown in Figure 4.

**Figure 6** shows a graph displaying radial pressure distribution across the radius of a 300mm wafer.

**Figure 7** shows an enlarged detailed cross sectional view of a portion of the support chamber and plating tank shown in Figure 5.

**Figure 8** shows a schematic block diagram showing the plating apparatus of the present invention including the pressure source and regulator.

**Figure 9** shows an enlarged detailed cross sectional view of an alternative embodiment of a portion of a support chamber in accordance with the present invention.

Referring now to the drawings, wherein like numerals indicate like elements, there is shown in Figures 4, 5 and 7 an apparatus for plating a wafer 10. The apparatus comprises a support chamber 12 and a plating tank 14. The support chamber 12 comprises a circumferential wall 16 having an open end 18. The support chamber 12 may be adapted to be movable along both the horizontal and vertical axes, relative to the plating tank 14. This allows for increased flexibility in positioning the support chamber 12.

In the preferred embodiment, the support chamber 12 is rotatable. Any suitable drive system may be used to rotate the support chamber 12. Such systems will be familiar to those skilled in the art and need not be described here in detail.

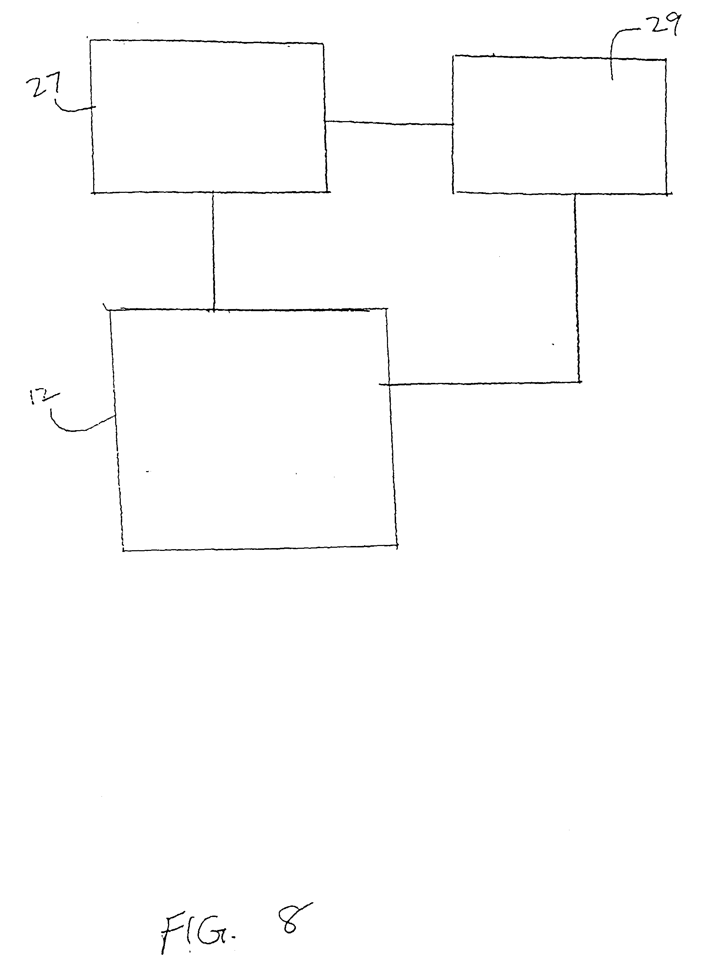

As shown in Figure 8, the circumferential wall 16 has a reduced diameter 17 adjacent the open end 18. The reduced diameter 17 terminates in a lip 20, which permits the circumferential wall 16 to support a wafer 10 above plating tank 14 and seal the edges of the wafer.

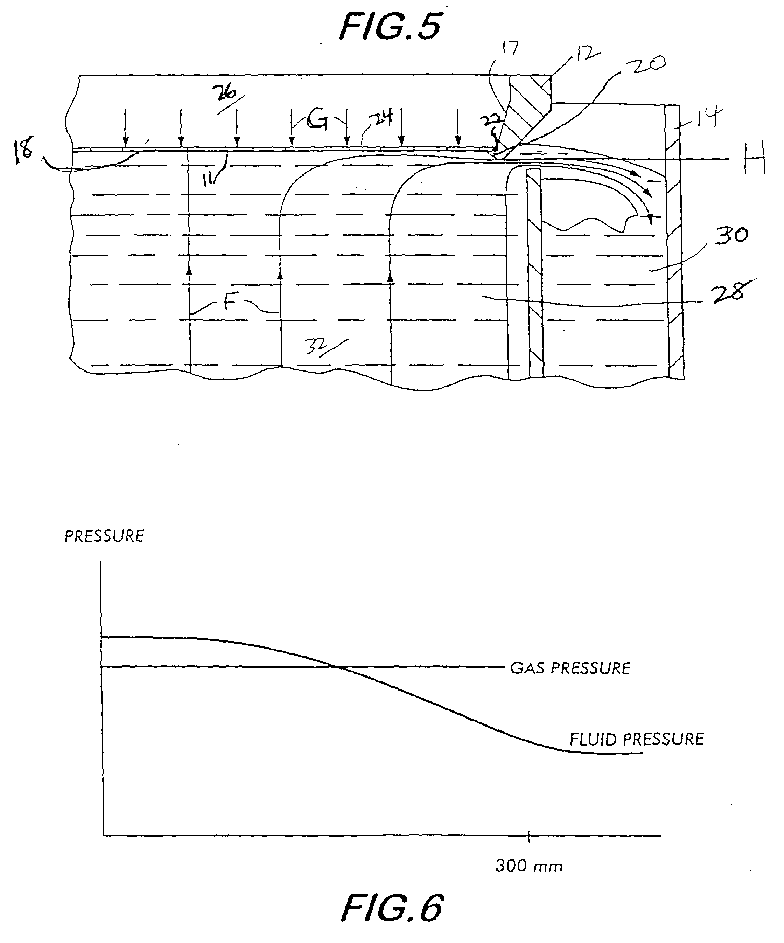

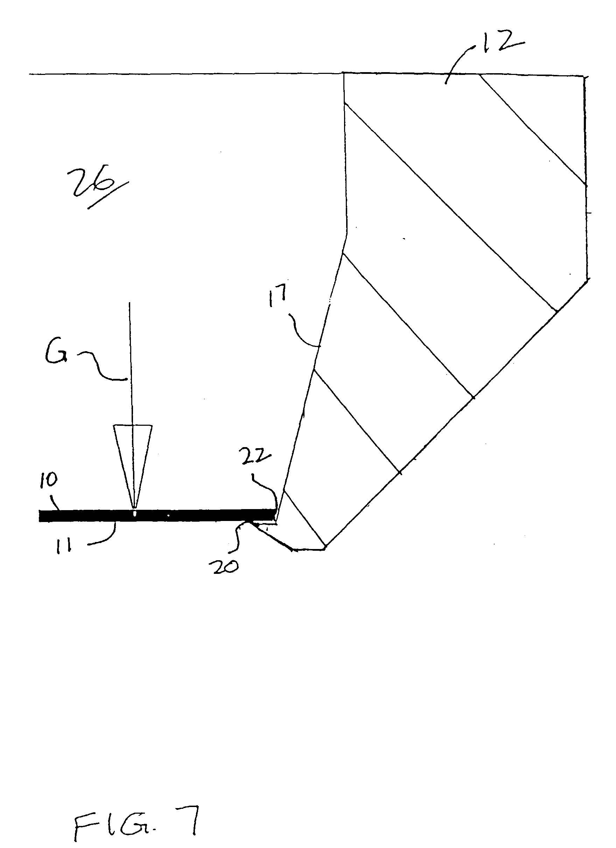

The circumferential wall 16 may include an internal taper 19 to form the reduced diameter 17 adjacent the open end 18, as shown in Figures 5 and 7. The tapered circumferential wall 16 acts to guide and self-center a wafer 10 in the open end 18.

In the preferred embodiment, an inwardly extending peripheral lip 20 is provided adjacent the open end 18 for supporting a wafer 10 thereon. As shown in Figure 5, a wafer 10 placed in the support chamber 12 rests against the lip 20, forming a non-rigid mechanical seal between the wafer 10 and the lip 20.

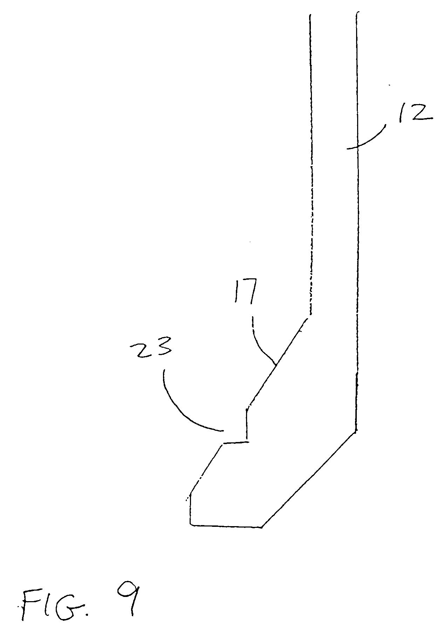

In an alternative embodiment of the preferred invention, a step-like circumferential ledge 23, shown in Figure 9, may be formed in the internal taper 19 of the circumferential wall 16. Like the peripheral lip 20 previously discussed, this ledge 23 will act as a resting surface to support the wafer 10 above the plating tank 14 and seal the edges of the wafer.

In an electrolytic plating process the edge of the wafer 10 is contacted by an electrode, not shown, imbedded in the lip 20. The electrode is adapted to contact an edge of a wafer placed in the support chamber. The electrode must be protected from the plating solution during the plating process to maintain its functionality. It is appreciated that the electrode may be positioned at any point in the support chamber such that proper contact with the wafer edge can be maintained.

To produce a sufficient seal between the wafer 10 and the lip 20, such that plating solution 32 cannot reach the edge 22 of the wafer 10 or the opposite side 24 of the wafer 10, a pressure medium is supplied by a pressure source 27, as shown in Figure 8, to an interior volume 26 within the support chamber 12. In the preferred embodiment, the pressure medium is a gas. When pressurized gas, shown in Figures 5 and 7 as arrows G, is supplied in the support chamber 12, the wafer 10 is pressed against the lip 20, forming a firm seal. The use of gas pressure to press the wafer 10 against the lip 20 and form a firm seal puts uniform pressure on wafer 10 and places less stress on the wafer 10 than existing plating devices and methods.

Unlike mechanical devices, which apply localized pressure to a wafer during the plating process, gas in the support chamber applies uniform pressure on the opposite side 24 of the wafer 10. The uniform application of gas pressure on the opposite side 24 of the wafer 10 prevents deformation and cracking of the wafer 10 during the plating process.

It is contemplated that the support chamber 12 described herein be used in combination with a plating tank 14, such as the ones shown in Figures 1 through 5, capable of imparting a laminar flow to plating solution 32 provided in the plating tank 14. This type of plating tank 14 is known to those in the art as a fountain plater. The plating tank 14 has an inner tank 28 and an outer tank 30. Plating solution 32 supplied in the plating tank 14 is circulated and given a laminar flow via a circulation pump 35, as shown in Figure 4. A baffle 37 is provided in the inner tank 28 above the pump 35 to minimize disturbances caused by pump 35 and impart laminar flow characteristics to plating solution 32. After passing through the baffle 37, plating solution 32 rises prominently in the inner tank 28, creating a liquid distribution having its highest point at the central portion of the plating tank 14. The height H of the plating solution 32 in the plating tank 14 can be raised or lowered by adjusting the flow rate of plating solution 32 via the pump 35. The plating solution 32 then spills over into the outer tank 30, to be recirculated.

Once a wafer is loaded into the support chamber 12, the support chamber 12 can be moved along the horizontal and vertical axes to properly position the wafer 10 relative to the plating tank 14 and plating solution 32.

When a wafer 10 is loaded into the support chamber 12, the pump 35 is turned off and the plating fluid level falls below the wafer 10 surface 11, resting at a static fluid level. This allows for loading a wafer 10 and positioning the support chamber without fluid contacting the wafer 10. Once the support chamber 12 is positioned and pressurized, the pump 35 is activated.

With appropriate diffusion of the fluid flow, a laminar flow is achieved, with the fluid level rising prominently as a fountain cylinder in the center portion of the plating tank. The vertical rise of the plating solution above the static fluid level is dependent on the wafer diameter and fluid flow rate. In a laminar flow system the vertical fluid rise Z can be approximated by the formula: 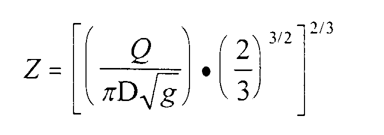 where Q= flow rate of fluid, and D=the diameter of the wafer to be plated. For a wafer with a diameter of 300 mm and a flow rate of 4 liters/sec, the fluid should rise by 18 mm. The surface of the wafer to be plated is positioned by the support chamber at approximately 6 mm below this height. This will provide the required fluid contact with the wafer at 12 mm above the static fluid level to achieve desired plating.

When the surface 11 of a wafer 10 to be plated is brought into contact with plating solution 32, pressure is produced at the wafer/fluid interface. Proper operation of the system depends on the balance of pressure between the gas pressure supplied in the support chamber 12 and the fluid pressure, exerted by the upwardly flowing plating solution on the coated surface 11 of the wafer 10. The flow and direction of the pressure exerted by the plating solution on the wafer 10 is shown in the drawings as flow lines F. Gas pressure G exerted on the wafer 10 from within the support chamber 12 must be higher than fluid pressure exerted by the upward flow of plating solution 32 at the edge 30 of the wafer 10. At the same time, to prevent excessive stress on the wafer 10, there cannot be a significant pressure difference between the gas pressure in the support chamber 12 and the fluid pressure.

Both objectives are achieved by the invention disclosed herein. Maintaining a support chamber 12 gas pressure higher than fluid pressure at the edge 22 of the wafer 10 insures that, if a surface imperfection exists at the edge 22 of the wafer 10, gas will leak from the support chamber 12 into the plating fluid 28, rather than fluid leaking into the support chamber 12. Any leaking gas bubbles are carried away from the coated surface 11 of the wafer 10 by the circulating fluid stream produced in the plating tank 14.

Gas pressure may be set and monitored by an external regulator 29, shown in Figure 8, to insure proper performance of the system. The regulator 29 may be adapted to measure the pressure in the support chamber, and to monitor, adjust, and regulate this pressure to maintain uniform pressure over the opposite side 24 the wafer 10.

When gas is supplied within the support chamber 12, gas pressure is uniform over the opposite side 24 of the wafer 10. Fluid pressure from the plating solution 32 is not uniform across the coated surface of the wafer 10 when contacted by plating solution 32. It can be shown using Bernoulli's equations, which are known to those skilled in the art and need not be described herein, that when the flow is uniform in the plating tank 14, producing a fountain cylinder at the center of the tank, fluid pressure is higher at the center of the wafer 10 than at the edge 30. By balancing the gas and fluid pressures at the center of the wafer 10, the desired effects of low stress on the wafer 10 and a gas pressure higher than fluid pressure at the edge 30 of the wafer 10 are accomplished. Figure 6 illustrates a graph showing radial pressure distribution across the radius of a 300mm wafer 10.

A method of plating a wafer 10 using features of the present invention comprises the following steps: The plating tank pump 35 is turned off. A wafer 10 is loaded into the support chamber 12, which is at ambient pressure. Gas pressure is then supplied within the support chamber 12, pressing the wafer 10 firmly against the peripheral lip 20, and the wafer 10 is then brought into position above the plating tank 14. Once the support chamber 12 is pressurized, the pump 35 is activated and the flow rate of plating solution 32 in the plating tank 14 is increased, raising the vertical height of plating solution 32 to achieve the desired contact with the wafer surface 11 for a preselected time period. At the end of the plating cycle, the pump 35 is turned off, allowing for the fluid level to drop. The wafer support chamber 12, while still under pressure, may be rotated, to remove excess fluid from the wafer 10 and peripheral lip 20 of the support chamber 12.

The present invention may be embodied in other specific forms without departing from the spirit or essential attributes thereof and, accordingly, reference should be made to the appended claims, rather than to the foregoing specification, as indicating the scope of the invention.

## Claims

1. An apparatus for plating a wafer, comprising:
a. a support chamber, said support chamber having a circumferential wall including an open end, said circumferential wall having a reduced diameter portion adjacent the open end defining a support for supporting a wafer above a plating tank, said support chamber having an interior volume for receiving a pressure medium; and
b. a plating tank, said plating tank having an open end for receiving the support chamber therein, said plating tank having a means for imparting a laminar flow to plating solution provided in said plating tank.

2. The apparatus for plating a wafer according to claim 1, wherein said pressure medium is a gas.

3. The apparatus for plating a wafer according to claim 1, wherein said circumferential wall further has an inwardly extending peripheral lip adjacent the open end for supporting a wafer thereon above the plating tank.

4. The apparatus for plating a wafer according to claim 3, wherein said peripheral lip prevents plating solution from contacting portions of said wafer to be left unplated.

5. The apparatus for plating a wafer according to claim 1, wherein the circumferential wall includes an internal taper to form the reduced diameter adjacent the open end.

6. The apparatus for plating a wafer according to claim 5, wherein the internal taper has a circumferential ledge for supporting the wafer above the plating tank.

7. The apparatus for plating a wafer according to claim 1, wherein said support chamber further comprises a source of gas under pressure.

8. The apparatus for plating a wafer according to claim 7, wherein said gas in said support chamber is supplied at a pressure higher than the fluid pressure at the interface adjacent the edge of the wafer and the plating solution.

9. The apparatus for plating a wafer according to claim 8, wherein said support chamber further includes a regulator for monitoring, adjusting and regulating the gas pressure supplied by the gas source in said support chamber.

10. The apparatus for plating a wafer according to claim 1, wherein said support chamber is rotatable.

11. The apparatus for plating a wafer according to claim 1, wherein said support chamber is movable relative to said plating tank.

12. The apparatus for plating a wafer according to claim 1, wherein the means for imparting a laminar flow to plating solution provided in said plating tank is adapted to cause said plating solution to rise to a preselected level.

13. The apparatus for plating a wafer according to claim 11, wherein the means for imparting a laminar flow to plating solution provided in said plating tank is a pump.

14. The apparatus for plating a wafer according to claim 1, wherein the support chamber further has an electrode for contacting an edge of said wafer.

15. The apparatus for plating a wafer according to claim 3, wherein the support chamber further has an electrode embedded in the lip for contacting an edge of said wafer.

16. A method for plating a wafer, comprising:
a. transferring a wafer to be plated to a support chamber;
b. supplying a gas under pressure in said support chamber;
c. bringing the wafer to be plated into contact with plating solution contained in a plating tank;
d. maintaining the plating solution in contact with the surface of said wafer for a preselected time;
e. separating the wafer to be plated from the plating solution.

17. The method of plating a wafer according to claim 16, wherein a further step comprises rotating the support chamber.

18. The method of plating a wafer according to claim 16, wherein the gas in said support chamber is supplied at a pressure higher than the fluid pressure at the interface adjacent the edge of the wafer and the plating solution.

19. The method of plating a wafer according to claim 16, wherein the wafer to be plated is brought into contact with plating solution contained in the plating tank by moving the support chamber into position relative to the plating tank.

20. The method of plating a wafer according to claim 16, wherein the wafer to be plated is brought into contact with plating solution contained in the plating tank by increasing the flow of plating solution in said plating tank such that the level of plating solution rises to a preselected level to meet the surface of said wafer to be plated.

21. The method of plating a wafer according to claim 16, wherein the wafer is separated from the plating fluid by decreasing the flow rate of the plating solution in the plating tank such that the level of plating fluid falls below the surface of the wafer.
